# EUROPEAN PATENT APPLICATION

(11) **EP 4 579 739 A1**
(43) Date of publication of application: **02.07.2025**
(21) Application number: 24218897.7
(22) Date of filing: 11.12.2024
(51) Int. Cl.: H01L 23/498, H01L 23/00

(54) **REDISTRIBUTION LAYER STRUCTURE, CORRESPONDING METHOD, PACKAGE DEVICE, AND MANUFACTURING SAID DEVICE**

(30) Priority: 28.12.2023 KR 20230193789; 17.10.2024 KR 20240141713
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a redistribution layer structure, a method of forming a redistribution layer structure, a semiconductor package device including a redistribution layer structure, and a method of manufacturing a semiconductor package device including a redistribution layer structure. The semiconductor package device may include a redistribution layer structure, wherein the redistribution layer structure may include a first insulating layer having one or more openings open to a target region and an unetched portion configured to improve the flatness of the redistribution layer structure in the remaining region excluding the one or more openings in the space corresponding to the target region and a first wiring member layer disposed on the first insulating layer so as to at least partially fill the one or more openings.

## Description

### BACKGROUND OF THE INVENTION

### 1. Field of the invention

The present invention relates to an electronic device/semiconductor device, components thereof, and a method of manufacturing the same, and more particularly to a redistribution layer structure, a device including the same, and a method of manufacturing the same.

### 2. Description of the Related Art

A redistribution layer (RDL) process is an important step in manufacture of a semiconductor device/electronic device. For example, in the manufacture of the semiconductor device, the RDL process may be usefully used to package a chip (i.e., die) and to connect the chip to an external circuit.

The RDL process may serve to relocate an electrode pad array of a semiconductor chip or an electrode pad array of a package substrate. The RDL process may be used as a method of eliminating design limitations of a chip manufactured in a semiconductor preprocess (i.e., front-end process) through a package. In addition, various package interconnection designs may be required in order to apply chips to various systems according to the demands of semiconductor chip customers, and the RDL process may be very useful because the RDL process can be used to replace design changes to electrical terminals. Furthermore, in advanced packaging processes, such as a fan-out process and a process in which a plurality of chips is packaged together, RDL technology may be effectively used to form a micro-connection pattern and to relocate input/output (I/O) terminals. In addition, the RDL process may be involved in improving the signal transfer capabilities of semiconductor chips, thermal management, etc. and may play a role in improving the performance, efficiency, etc. of semiconductor chips in many ways.

The RDL process may include forming an insulating layer having a via hole (opening), forming a seed layer, forming a mask pattern, electroplating a wiring layer, and removing the mask pattern. It is necessary to secure a via hole having an appropriate size in order to connect a signal trace to an electrode pad of a chip or a substrate. It is preferable for the size of the via hole to be large in order to improve electrical connectivity. If the size of the via hole is large, however, a topology problem may occur after electroplating the wiring layer. As the size of the chip is reduced and the pattern becomes finer, the diameter of via hole may be reduced to tens of micrometers or less, but the size of the via hole may still be large enough to cause the topology problem, which may lead to low reliability. For example, if the size of the via hole is large, bending and sagging (sagging of a pattern portion) may occur in a redistribution layer (RDL), which may cause electrical short circuit, resulting in an increased defect rate and reduced reliability.

### SUMMARY OF THE INVENTION

It is an object of the present invention to provide a redistribution layer (RDL) structure capable of improving topology and flatness, thereby improving reliability, and a device (e.g., semiconductor package device) including the same.

It is another object of the present invention to provide a method of forming the redistribution layer (RDL) structure and a method of manufacturing a device (e.g., semiconductor package device) to which the same is applied.

Objects of the present invention are not limited to the aforementioned objects, and other unmentioned objects will be understood by those skilled in the art based on the following description.

In accordance with one aspect of the present invention, the above and other objects can be accomplished by the provision of a semiconductor package device including a chip and a redistribution layer structure electrically connected to the chip, wherein the redistribution layer structure includes a first insulating layer having one or more openings open to a given target region within a size range of the target region, the one or more openings being regions in which electrically identical elements to which the same electrical signal is applied are formed, and having an unetched portion configured to improve the flatness of the redistribution layer structure in the remaining region excluding the one or more openings in a space corresponding to the target region, the unetched portion being disposed between two or more openings or disposed such that more than half of the unetched portion is surrounded by one opening, and a first wiring member layer disposed on the first insulating layer so as to at least partially fill the one or more openings, the first wiring member layer including the electrically identical elements formed in the one or more openings.

The first insulating layer may include a plurality of openings formed in the target region so as to be spaced apart from each other, and the unetched portion may be provided between the plurality of openings.

The first insulating layer may include an opening having a ring structure or a partial ring structure in the target region, and the unetched portion may be provided so as to be surrounded by the ring structure or the partial ring structure.

At least a part of the unetched portion may be located in a region corresponding to a central part of the target region.

The one or more openings may have a diameter or line width of about 1 to 10 um.

The target region may be a given surface region of one electrode pad or a region corresponding thereto.

The redistribution layer structure may further include a second insulating layer disposed on the first insulating layer so as to at least partially cover the first wiring member layer and a second wiring member layer disposed on the second insulating layer.

The target region may be a first target region, the one or more openings may be first openings, the unetched portion may be a first unetched portion, and the electrically identical elements may be first electrically identical elements. The second insulating layer may have one or more second openings open to a given second target region of the first wiring member layer within a size range of the second target region, the one or more second openings being regions in which second electrically identical elements to which the same electrical signal is applied are formed, and the second insulating layer may have a second unetched portion configured to improve the flatness of the redistribution layer structure in the remaining region excluding the one or more second openings in a space corresponding to the second target region, the second unetched portion being disposed between two or more second openings or disposed such that more than half of the second unetched portion is surrounded by one second opening. The second wiring member layer may be disposed on the second insulating layer so as to at least partially fill the one or more second openings, and may include the second electrically identical elements formed in the one or more second openings.

The second insulating layer may include a plurality of second openings formed in the second target region so as to be spaced apart from each other, and the second unetched portion may be provided between the plurality of second openings.

The second insulating layer may include a second opening having a ring structure or a partial ring structure in the second target region, and the second unetched portion may be provided so as to be surrounded by the ring structure or the partial ring structure.

In accordance with another aspect of the present invention, there is provided a method of forming a redistribution layer structure, the method including forming a first insulating layer having one or more openings open to a given target region within a size range of the target region, the one or more openings being regions in which electrically identical elements to which the same electrical signal is applied are formed, and having an unetched portion configured to improve the flatness of the redistribution layer structure in the remaining region excluding the one or more openings in a space corresponding to the target region, the unetched portion being disposed between two or more openings or disposed such that more than half of the unetched portion is surrounded by one opening; and forming a first wiring member layer disposed on the first insulating layer so as to at least partially fill the one or more openings, the first wiring member layer including the electrically identical elements formed in the one or more openings.

The first insulating layer may include a plurality of openings formed in the target region so as to be spaced apart from each other, and the unetched portion may be provided between the plurality of openings.

The first insulating layer may include an opening having a ring structure or a partial ring structure in the target region, and the unetched portion may be provided so as to be surrounded by the ring structure or the partial ring structure.

The target region may be a given surface region of one electrode pad or a region corresponding thereto.

The method may further include forming a second insulating layer on the first insulating layer so as to at least partially cover the first wiring member layer and forming a second wiring member layer on the second insulating layer.

The target region may be a first target region, the one or more openings may be first openings, the unetched portion may be a first unetched portion, and the electrically identical elements may be first electrically identical elements. The second insulating layer ma have one or more second openings open to a given second target region of the first wiring member layer within a size range of the second target region, the one or more second openings being regions in which second electrically identical elements to which the same electrical signal is applied are formed, and the second insulating layer may have a second unetched portion configured to improve the flatness of the redistribution layer structure in the remaining region excluding the one or more second openings in a space corresponding to the second target region, the second unetched portion being disposed between two or more second openings or disposed such that more than half of the second unetched portion is surrounded by one second opening. The second wiring member layer may be disposed on the second insulating layer so as to at least partially fill the one or more second openings, and may include the second electrically identical elements formed in the one or more second openings.

The second insulating layer may include a plurality of second openings formed in the second target region so as to be spaced apart from each other, and the second unetched portion may be provided between the plurality of second openings.

The second insulating layer may include a second opening having a ring structure or a partial ring structure in the second target region, and the second unetched portion may be provided so as to be surrounded by the ring structure or the partial ring structure.

In accordance with another aspect of the present invention, there is provided a method of manufacturing a semiconductor package device including a chip and a redistribution layer structure electrically connected to the chip, the method of manufacturing the semiconductor package device including forming the redistribution layer structure using the method of forming the redistribution layer structure.

The method of manufacturing the semiconductor package device may be based on a wafer level package (WLP) method or a panel level package (PLP) method.

### BRIEF DESCRIPTION OF THE DRAWINGS

FIG. 1A is a sectional view illustrating a redistribution layer structure according to an embodiment of the present invention;
FIG. 1B is a plan view showing the shape and disposition of a plurality of openings in a first insulating layer of FIG. 1A;
FIG. 2A is a sectional view illustrating a redistribution layer structure according to another embodiment of the present invention;
FIG. 2B is a plan view showing the shape of an opening in a first insulating layer of FIG. 2A;
FIG. 3A is a sectional view illustrating a redistribution layer structure according to a comparative example;
FIG. 3B is a plan view showing the shape of an opening in a first insulating layer of FIG. 3A;
FIGs. 4 to 7 are plan views exemplarily showing the disposition of a plurality of openings in a first insulating layer applicable to the redistribution layer structure according to the other embodiment of the present invention;
FIG. 8 is a plan view exemplarily showing the shape and disposition of an opening in a first insulating layer applicable to the redistribution layer structure according to the other embodiment of the present invention;
FIG. 9 is a sectional view illustrating a redistribution layer structure according to a comparative example and problems thereof;
FIG. 10 is a sectional view illustrating a redistribution layer structure according to another embodiment of the present invention;
FIG. 11 is a sectional view illustrating a redistribution layer structure according to a comparative example and problems thereof;
FIG. 12 is a sectional view illustrating a redistribution layer structure according to another embodiment of the present invention;
FIGs. 13A to 13C are sectional views showing a method of forming a redistribution layer structure according to an embodiment of the present invention;
FIGs. 14A to 14D are sectional views showing a method of forming a redistribution layer structure according to another embodiment of the present invention;
FIGs. 15A to 15D are sectional views showing a method of manufacturing a semiconductor package device to which a method of forming a redistribution layer structure according to an embodiment of the present invention is applied;
FIGs. 16A to 16E are sectional views showing a method of manufacturing a semiconductor package device to which a method of forming a redistribution layer structure according to another embodiment of the present invention is applied;
FIG. 17 is a sectional photographic image showing a part of a semiconductor package device manufactured according to a comparative example;
FIG. 18 is a sectional photographic image showing a part of a semiconductor package device manufactured according to an embodiment of the present invention; and
FIG. 19 is a photographic image showing a part of a surface portion of a semiconductor package device manufactured according to an embodiment of the present invention.

### DETAILED DESCRIPTION OF THE PREFERRED EMBODIMENTS

Hereinafter, embodiments of the present invention will be described in detail with reference to the accompanying drawings. The sizes or thicknesses of the regions or parts shown in the accompanying drawings may be somewhat exaggerated for clarity and ease of description. Throughout the detailed description, the same reference symbols denote the same components.

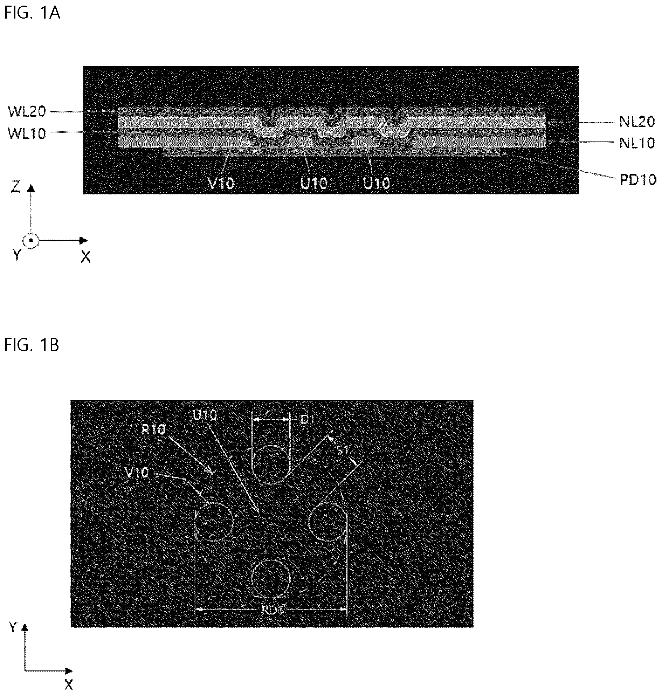

FIG. 1A is a sectional view illustrating a redistribution layer structure according to an embodiment of the present invention. FIG. 1B is a plan view showing the shape and disposition of a plurality of openings in a first insulating layer of FIG. 1A.

Referring to FIGs. 1A and 1B, the redistribution layer structure according to the embodiment of the present invention may include a first insulating layer NL10 disposed on a predetermined support surface (bottom surface) and a first wiring member layer WL10 disposed on the first insulating layer NL10. The first insulating layer NL10 may have one or more openings V10 that are open to a given target region R10 (FIG. 1B). The one or more openings V10 may be open to the target region R10 within a size range of the target region R10. The first wiring member layer WL10 may be disposed on the first insulating layer NL10 so as to at least partially fill the one or more openings V10. In the present embodiment, the first insulating layer NL10 may have a plurality of openings V10. The opening V10 may be referred to as a via hole or a via. When viewed from above, the opening V10 may have a circular shape, an oval shape, a quadrangular shape, or a quadrangular shape with rounded corners. The target region R10 is the region in which the plurality of openings V10 is formed, which may also be referred to as a region of interest. When viewed from above, the target region R10 may have a circular shape, an oval shape, a quadrangular shape, or a quadrangular shape with rounded corners.

The one or more openings V10, i.e., the plurality of openings V10, may be the regions in which electrically identical elements (identical bodies) to which the same electrical signal is applied are formed. The same electrical signal may be simultaneously applied to the electrically identical elements. An unetched portion U10 configured to improve the flatness of the redistribution layer structure may be provided in the remaining region of the first insulating layer NL10, excluding the one or more openings V10, i.e., the plurality of openings V10, in the space corresponding to the target region R10. The unetched portion U10 is the part of the first insulating layer NL10 that has not been etched (removed), and may be disposed between two or more openings V10, i.e., between the plurality of openings V10. An unetched region of the first insulating layer NL10 may extend to the outside of the target region R10.

The first wiring member layer WL10 may include electrically identical elements (identical bodies) formed in the one or more openings V10, i.e., the plurality of openings V10. The same electrical signal may be simultaneously applied to the electrically identical elements formed in the plurality of openings V10. The electrically identical elements may be conductors configured to at least partially fill the openings V10.

In the present embodiment, the first insulating layer NL10 may include a plurality of openings V10 formed in the target region R10 so as to be spaced apart from each other. In other words, the plurality of divided (i.e., segmented) openings V10 may be disposed in the target region R10 so as to be spaced apart from each other. As a non-limiting example, the plurality of openings V10 may be disposed approximately at respective vertices of a quadrangle. In addition, as a non-limiting example, the plurality of openings V10 may be disposed so as to abut the edge (end) of the target region R10. The unetched portion U10 may be provided between the plurality of openings V10. In an example, at least a part of the unetched portion U10 may be disposed so as to correspond to a central part of the target region R10.

Each of the one or more openings V10 may have a diameter or line width within, for example, a range of about 1 to 10 um. In the embodiment of FIG. 1B, each of the plurality of openings V10 may have a diameter D1 within, for example, a range of about 1 to 10 um or a range of about 3 to 10 um. The spacing S1 between the plurality of openings V10 may be, for example, about 0.1 to 20 um. Meanwhile, the diameter (or width) RD1 of the target region R10 may be, for example, about 10 to 30 um. In a specific example, the diameter RD1 of the target region R10 may be about 20 pm, the diameter D1 of the opening V10 may be about 5 um, and the minimum spacing S1 between two adjacent openings V10 may be about 5.61 um. However, the size of the target region R10, the size of the opening V10, and the range of spacing between the openings V10 are exemplary only, and may be variously changed.

According to the embodiment of the present invention, the target region R10 may be a given surface region of one electrode pad PD10 or a region corresponding thereto. The electrode pad PD10 may be formed on a predetermined substructure. For example, the electrode pad PD10 may be an electrode pad (bonding pad) of a chip (i.e., die) or an electrode pad (bonding pad) of a package substrate. A plurality of openings V10 may be formed for one electrode pad PD10, and electrically identical elements (via wiring portions) connected to the electrode pad PD10 may be formed in the plurality of openings V10.

The redistribution layer structure may further include a second insulating layer NL20 disposed on the first insulating layer NL10 so as to at least partially cover the first wiring member layer WL10 and a second wiring member layer WL20 disposed on the second insulating layer NL20. However, the second insulating layer NL20 and the second wiring member layer WL20 may not be provided. In addition, if necessary, one or more additional insulating layers and one or more additional wiring member layers may be alternately formed on the second wiring member layer WL20.

Each of the first and second insulating layers NL10 and NL20 may be an organic insulating layer or an inorganic insulating layer. The first and second insulating layers NL10 and NL20 may be made of the same material or may be made of different materials. Each of the first and second wiring member layers WL10 and WL20 may be made of a conductive material, such as a metal, an alloy, or a metal compound. Each of the first and second wiring member layers WL10 and WL20 may be formed by, as a non-limiting example, forming a seed layer on the front of the bottom surface, forming a mask pattern on the seed layer, forming a wiring layer from the part of the seed layer exposed by the mask pattern using an electroplating method, and removing the mask pattern and the part of the seed layer thereunder. Each of the first and second wiring member layers WL10 and WL20 may include, for example, a Cu wire, but the material for wiring is not limited to Cu and may be variously changed. A wiring material used in a general redistribution layer may be applicable to each of the first and second wiring member layers WL10 and WL20.

According to the embodiment of the present invention, the topology and flatness of the redistribution layer structure may be improved not by forming a large opening (via) corresponding to the entirety of the target region R10 but by forming a plurality of mutually spaced small openings (vias) V10 with respect to the target region R10 to retain a given unetched portion U10 on the target region R10. Consequently, it is possible to prevent problems such as bending and sagging (sagging of a pattern portion) due to the large opening (via) while securing excellent electrical connectivity between components, and therefore it is possible to reduce the defect rate of devices and to improve reliability.

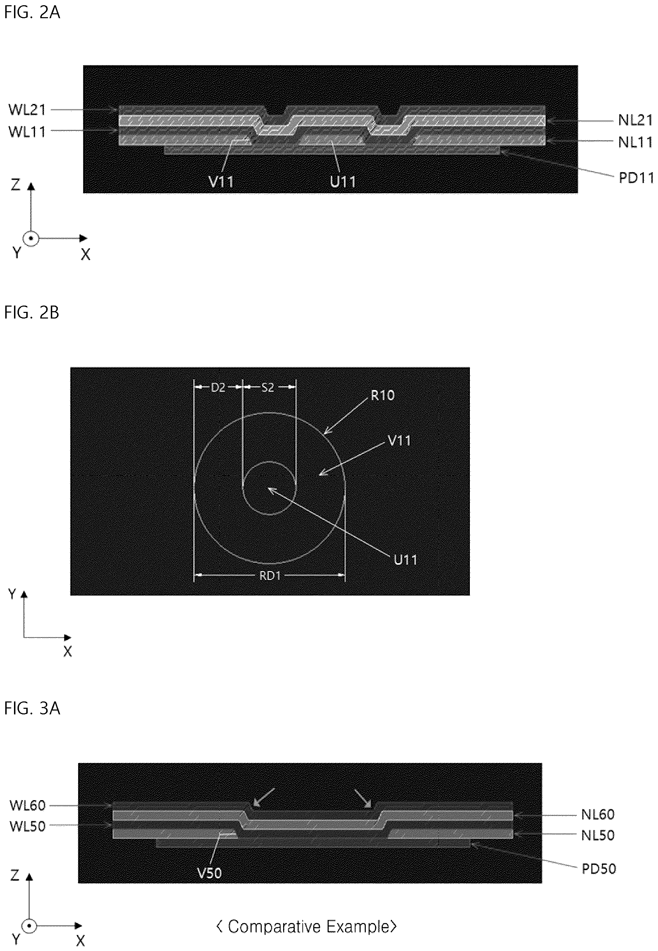

FIG. 2A is a sectional view illustrating a redistribution layer structure according to another embodiment of the present invention. FIG. 2B is a plan view showing the shape of an opening in a first insulating layer of FIG. 2A.

Referring to FIGs. 2A and 2B, the redistribution layer structure according to the present embodiment may include a first insulating layer NL11 disposed on a predetermined support surface (bottom surface) and a first wiring member layer WL11 disposed on the first insulating layer NL11. The first insulating layer NL11 may have one or more openings V11 that are open to a given target region R10 (FIG. 2B). The one or more openings V11 may be open to the target region R10 within a size range of the target region R10. The first wiring member layer WL11 may be disposed on the first insulating layer NL11 so as to at least partially fill the one or more openings V11. In the present embodiment, the first insulating layer NL11 may have a single opening V11.

The one or more openings V11, i.e., the single opening V11, may be the regions in which electrically identical elements (identical bodies) to which the same electrical signal is applied are formed. The same electrical signal may be simultaneously applied to the electrically identical elements. An unetched portion U11 configured to improve the flatness of the redistribution layer structure may be provided in the remaining region of the first insulating layer NL11, excluding the one or more openings V11, i.e., the single opening V11, in the space corresponding to the target region R10. The unetched portion U11 is the part of the first insulating layer NL11 that has not been etched (removed), and may be disposed such that more than half of the unetched portion is surrounded by the single opening V11. An unetched region of the first insulating layer NL11 may be provided outside the target region R10.

The first wiring member layer WL11 may include electrically identical elements (identical bodies) formed in the one or more openings V11, i.e., the single opening V11. The same electrical signal may be simultaneously applied to the electrically identical elements formed in the single opening V10. The electrically identical elements may be conductors configured to at least partially fill the opening V11.

In the present embodiment, the first insulating layer NL11 may have an opening V11 having a ring structure or a partial ring structure in the target region R10. The unetched portion U11 may be provided so as to be surrounded by the opening V11 having the ring structure or the partial ring structure. For example, the opening V11 may have a ring structure, in which case the unetched portion U11 may be completely surrounded by the ring structure. The ring structure may be referred to as a donut structure, and the partial ring structure may be referred to as a partial donut structure. In an example, at least a part of the unetched portion U11 may be located in a region corresponding to a central part of the target region R10.

Each of the one or more openings V11 may have a diameter or line width within, for example, a range of about 1 to 10 um. In the embodiment of FIG. 2B, the opening V11 may have a line width D2 within, for example, a range of about 1 to 10 um or a range of about 3 to 10 um. The width (or diameter) S2 of the unetched portion U11 may be, for example, about 0.1 to 20 um or about 1 to 20 um. Meanwhile, the diameter (or width) RD1 of the target region R10 may be, for example, about 10 to 30 um. In a specific example, the diameter RD1 of the target region R10 may be about 20 µm, the line width D2 of the opening V11 may be about 6.5 um, and the width S2 of the unetched portion U11 may be about 7.0 um. However, the size of the target region R10, the size of the opening V11, and the size range of the unetched portion U11 are exemplary only, and may be variously changed.

According to the embodiment of the present invention, the target region R10 may be a given surface region of one electrode pad PD11 or a region corresponding thereto. The electrode pad PD11 may be formed on a predetermined substructure. For example, the electrode pad PD11 may be an electrode pad (bonding pad) of a chip (i.e., die) or an electrode pad (bonding pad) of a package substrate. A ring-shaped or partial ring-shaped opening V11 may be formed for one electrode pad PD10, and electrically identical elements (via wiring portions) connected to the electrode pad PD11 may be formed in the openings V11.

The redistribution layer structure may further include a second insulating layer NL21 disposed on the first insulating layer NL11 so as to at least partially cover the first wiring member layer WL11 and a second wiring member layer WL21 disposed on the second insulating layer NL21. The second insulating layer NL21 and the second wiring member layer WL21 may not be provided. One or more additional insulating layers and one or more additional wiring member layers may be alternately formed on the second wiring member layer WL21.

According to the embodiment of the present invention, the topology and flatness of the redistribution layer structure may be improved not by forming a large opening (via) corresponding to the entirety of the target region R10 but by forming a ring-shaped or partial ring-shaped opening (via) V11 with respect to the target region R10 to retain a given unetched portion U11 on the target region R10. Consequently, it is possible to prevent problems such as bending and sagging (sagging of a pattern portion) due to the large opening (via) while securing excellent electrical connectivity between components, and therefore it is possible to reduce the defect rate of devices and to improve reliability.

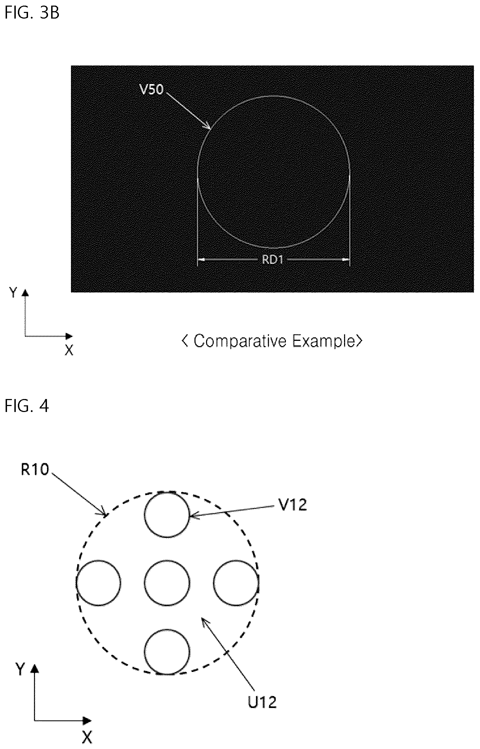

FIG. 3A is a sectional view illustrating a redistribution layer structure according to a comparative example. FIG. 3B is a plan view showing the shape of an opening in a first insulating layer of FIG. 3A.

Referring to FIGs. 3A and 3B, the redistribution layer structure according to the comparative example may include a first insulating layer NL50, a first wiring member layer WL50, a second insulating layer NL60, and a second wiring member layer WL60 disposed on a substructure including an electrode pad PD50. The first insulating layer NL50 may have an opening V50 configured to expose the electrode pad PD50, and the first wiring member layer WL50 may be formed so as to extend over the first insulating layer NL50 while substantially filling the opening V50.

In the comparative example, the opening V50 may have a diameter (width) of, for example, about 20 um. As such, if the size of the opening V50 is relatively large, the opening V50 may cause topology and flatness problems in the redistribution layer structure formed thereon, resulting in relatively large bending and sagging (sagging of a pattern portion). As a result, in some cases, electrical short circuit may occur, which may lead to increased defect rates, reduced reliability, and the like.

However, according to the embodiments of the present invention, it is possible to solve the topology and flatness problems of the redistribution layer structure by forming a plurality of mutually spaced openings (vias) for the target region R10 or by forming an opening having a ring or partial ring shape, as previously described with reference to FIGs. 1A to 2B.

When the plurality of mutually spaced openings (vias) is formed for the target region R10 in the embodiment of the present invention, the number, the array form, etc. of the plurality of openings (vias) may be variously changed. Various modifications are shown in FIGs. 4 to 7.

FIGs. 4 to 7 are plan views exemplarily showing the disposition of a plurality of openings in a first insulating layer applicable to the redistribution layer structure according to the other embodiment of the present invention.

Referring to FIG. 4, a plurality of openings V12 may be formed for the target region R10, and an unetched portion U12 may be provided therebetween. The plurality of openings V12 may have an array form similar to those of FIG. 1B, but may have a shape somewhat modified from those of FIG. 1B. One of the plurality of openings V12 may be disposed so as to correspond to a central part of the target region R10 or a part adjacent thereto.

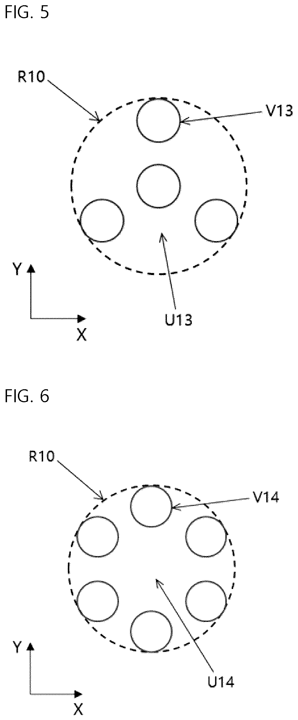

Referring to FIG. 5, a plurality of openings V13 may be formed for the target region R10, and an unetched portion U13 may be provided therebetween. The plurality of openings V13 may have an array form similar to those of FIG. 4, but may have a shape somewhat modified from those of FIG. 4. The openings disposed at the edge of the target region R10 may be disposed so as to approximately correspond to, for example, respective vertices of a triangle.

Referring to FIG. 6, a plurality of openings V14 may be formed for the target region R10, and an unetched portion U14 may be provided therebetween. The plurality of openings V14 may have an array form similar to those of FIG. 1B, but may have a shape somewhat modified from those of FIG. 1B. The plurality of openings V14 may be disposed so as to approximately correspond to, for example, respective vertices of a hexagon.

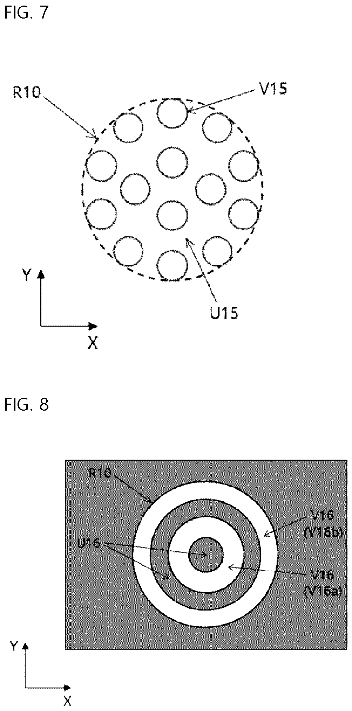

Referring to FIG. 7, a plurality of openings V15 may be formed for the target region R10, and an unetched portion U15 may be provided therebetween. A relatively large number of openings V15 may be formed for the target region R10 so as to be spaced apart from each other.

However, the number, shape, disposition, and the like of the plurality of openings shown in FIGs. 4 to 7 are exemplary, and various other modifications may be possible.

In addition, when the ring or partial ring-shaped opening (via) is formed for the target region R10 in the embodiment of the present invention, the number, the array form, etc. of openings (via) may be variously changed. One modification is shown in FIG. 8.

FIG. 8 is a plan view exemplarily showing the shape and disposition of an opening in a first insulating layer applicable to the redistribution layer structure according to the other embodiment of the present invention.

Referring to FIG. 8, a plurality of openings V16 may be formed for the target region R10, and an unetched portion U16 may be provided therebetween and therearound. At least one of the plurality of openings V16 may have a ring structure or a partial ring structure. For example, the plurality of openings V16 may have ring structures and may have different sizes. The plurality of openings V16 may be disposed so as to be concentric outward from the center of the target region R10. The inwardly formed opening V16 may be referred to as a first opening V16a, and the outwardly formed opening V16 may be referred to as a second opening V16b. In the present embodiment, at least two unetched portions U16 may be spaced apart from each other.

However, the number, shape, disposition, etc. of the openings shown in FIG. 8 are exemplary, and various other variations may be possible.

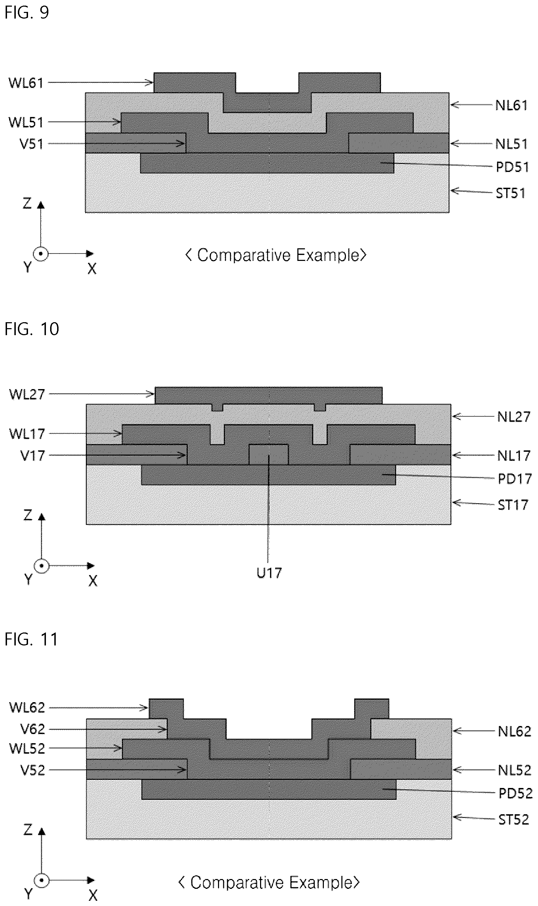

FIG. 9 is a sectional view illustrating a redistribution layer structure according to a comparative example and problems thereof.

Referring to FIG. 9, the redistribution layer structure according to the comparative example may have a structure similar to that described with reference to FIG. 3. The redistribution layer structure according to the comparative example may include a first insulating layer NL51, a first wiring member layer WL51, a second insulating layer NL61, and a second wiring member layer WL61 disposed on a substructure ST51 including an electrode pad PD51. The first insulating layer NL51 may have an opening V51 configured to expose the electrode pad PD51, and the first wiring member layer WL51 may be formed so as to extend over the first insulating layer NL51 while approximately filling the opening V51.

If the opening V51 of the first insulating layer NL51 is large, the first wiring member layer WL51 may be relatively largely bent even if the opening V51 is filled with a metal material to some extent through a plating process of forming the first wiring member layer WL51. As a result, the surfaces of the second insulating layer NL61 and the second wiring member layer WL61 above the opening V51 may be distorted due to the step height of the opening V51, as shown in FIG. 9. In other words, high topology may cause difficulties in forming subsequent layers.

FIG. 10 is a sectional view illustrating a redistribution layer structure according to another embodiment of the present invention.

Referring to FIG. 10, the redistribution layer structure according to the present embodiment may have a configuration corresponding to the redistribution layer structure described with reference to FIG. 1A or 2A. The redistribution layer structure according to the present embodiment may include a first insulating layer NL17, a first wiring member layer WL17, a second insulating layer NL27, and a second wiring member layer WL27 disposed on a substructure ST17 including an electrode pad PD17. The first insulating layer NL17 may have one or more openings V17 configured to expose the electrode pad PD17, and the first wiring member layer WL17 may be formed so as to extend over the first insulating layer NL17 while at least partially filling the one or more openings V17.

The one or more openings V17 may be open to a given target region within a size range of the target region. The one or more openings V17 may be the regions in which electrically identical elements (identical bodies) to which the same electrical signal is applied are formed. An unetched portion U17 configured to improve the flatness of the redistribution layer structure may be provided in the remaining region of the first insulating layer NL17, excluding the one or more openings V17, in the space corresponding to the target region. The unetched portion U17 may be disposed between two or more openings, or may be disposed such that more than half of the unetched portion is surrounded by one opening. For example, the first insulating layer NL17 and the one or more openings V17 may have a configuration corresponding to any one of the embodiments described with reference to FIGs. 1A, 1B, 2A, 2B, and 4 to 8. The first wiring member layer WL17 may include the electrically identical elements formed in the one or more openings V17.

In the embodiment of the present invention, the problems of the comparative example described with reference to FIG. 9 may be overcome by dividing one large opening (via) into several small openings (vias) or by forming an opening (via) having a ring (donut) structure or a partial ring (donut) structure. The opening V17 of the first insulating layer NL17 according to the embodiment of the present invention may be better filled by plating, and the impact of the step height at the opening V17 of the first insulating layer NL17 on the second insulating layer NL27 and the second wiring member layer WL27 may be reduced, thereby greatly improving the flatness of the layers. After the formation of the first wiring member layer WL17, therefore, processes of forming subsequent layers may be easily performed.

In FIG. 10, the layer shown as the first wiring member layer WL17 may be a first wiring element, and the layer shown as the second wiring member layer WL27 may be a second wiring element. The first wiring element and the second wiring element may or may not be electrically connected to each other. In addition, although only the first and second wiring elements are shown herein for convenience, the first wiring member layer WL17 may further include wiring elements other than the first wiring element, and the second wiring member layer WL27 may further include wiring elements other than the second wiring element.

FIG. 11 is a sectional view illustrating a redistribution layer structure according to a comparative example and problems thereof.

Referring to FIG. 11, the redistribution layer structure according to the comparative example may include a first insulating layer NL52, a first wiring member layer WL52, a second insulating layer NL62, and a second wiring member layer WL62 disposed on a substructure ST52 including an electrode pad PD52. The first insulating layer NL52 may have a first opening V52 configured to expose the electrode pad PD52, and the first wiring member layer WL52 may be formed so as to extend over the first insulating layer NL52 while approximately filling the first opening V52. The second insulating layer NL62 may have a second opening V62 configured to expose the first wiring member layer WL52, and the second wiring member layer WL62 may be formed so as to extend over the second insulating layer NL62 while partially filling the second opening V62. A part of the first wiring member layer WL52 and a part of the second wiring member layer WL62 may be in direct contact with each other.

As shown in FIG. 11, when the openings (vias) are stacked, i.e., when the second opening (V62) is formed on the first opening (V52), it is more difficult to fill the stacked openings (vias) with a wiring material, whereby high topology may be present and great bending may be generated in the redistribution layer structure above the stacked openings (vias).

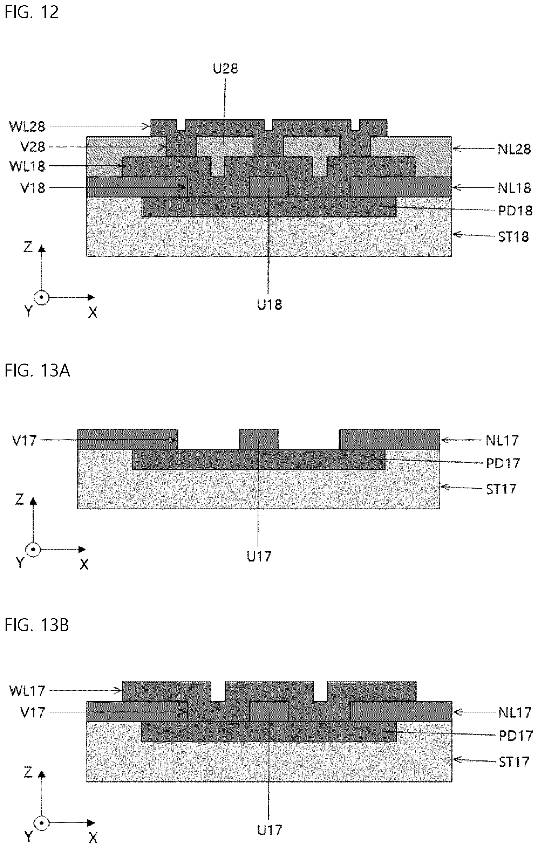

FIG. 12 is a sectional view illustrating a redistribution layer structure according to another embodiment of the present invention.

Referring to FIG. 12, the redistribution layer structure according to the present embodiment may include a first insulating layer NL18, a first wiring member layer WL18, a second insulating layer NL28, and a second wiring member layer WL28 disposed on a substructure ST18 including an electrode pad PD18. The first insulating layer NL18 may have one or more first openings V18 configured to expose the electrode pad PD18, and the first wiring member layer WL18 may be formed so as to extend over the first insulating layer NL18 while at least partially filling the one or more first openings V18. The second insulating layer NL28 may have one or more second openings V28 configured to expose the first wiring member layer WL18, and the second wiring member layer WL28 may be formed so as to extend over the second insulating layer NL28 while at least partially filling the one or more second openings V28.

The one or more first openings V18 may be open to a given first target region within a size range of the first target region. The one or more first openings V18 may be the regions in which first electrically identical elements (identical bodies) to which the same electrical signal is applied are formed. A first unetched portion U18 configured to improve the flatness of the redistribution layer structure may be provided in the remaining region of the first insulating layer NL18, excluding the one or more openings V18, in the space corresponding to the first target region. The first unetched portion U18 may be disposed between two or more first openings, or may be disposed such that more than half of the first unetched portion is surrounded by one first opening. For example, the first insulating layer NL18 and the one or more first openings V18 may have a configuration corresponding to any one of the embodiments described with reference to FIGs. 1A, 1B, 2A, 2B, and 4 to 8. The first wiring member layer WL18 may include the first electrically identical elements formed in the one or more first openings V18.

The second insulating layer NL28 may have one or more second openings V28 that are open to a given second target region of the first wiring member layer WL18 within a size range of the second target region. The one or more second openings V28 may be the regions in which second electrically identical elements (identical bodies) to which the same electrical signal is applied are formed. The same electrical signal may be simultaneously applied to the second electrically identical elements. The second insulating layer NL28 may have a second unetched portion U28 configured to improve the flatness of the redistribution layer structure in the remaining region excluding the one or more second openings V28 in the space corresponding to the second target region. The second unetched portion U28 may be disposed between two or more second openings, or may be disposed such that more than half of the second unetched portion is surrounded by one second opening. The second wiring member layer WL28 may be disposed on the second insulating layer NL28 so as to at least partially fill the one or more second openings V28, and may include the second electrically identical elements formed in the one or more second openings V28. The second electrically identical elements may be electrically connected to the first electrically identical elements.

The one or more second openings V28 may have a planar structure identical or similar to the planar structure of the one or more openings described in the embodiments of FIGs. 1A, 1B, 2A, 2B, and 4 to 8. Consequently, the second insulating layer NL28 may include a plurality of second openings V28 formed in the second target region so as to be spaced apart from each other, and the second unetched portion U28 may be provided between the plurality of second openings V28. Alternatively, the second insulating layer NL28 may include a second opening V28 having a ring structure or a partial ring structure in the second target region, and the second unetched portion U28 may be provided so as to be surrounded by the ring structure or the partial ring structure. In addition, the one or more second openings V28 may be disposed so as not to overlap the one or more first openings V18, may be disposed so as to partially overlap the one or more first openings V18, or may be disposed so as to be misaligned with the one or more first openings V18. Furthermore, the shape and disposition of the one or more second openings V28 may be variously changed.

According to the embodiment of the present invention, the openings (vias) having relatively small widths (diameters/line widths) in the first insulating layer NL18 and the second insulating layer NL28 may be disposed so as to be misaligned with each other or to only partially overlap each other, whereby it is possible to prevent direct stacking of the openings (vias) and to improve the filling characteristics of the openings (vias). As a result, the surface of the second wiring member layer WL28 may be very flat, compared to the comparative example of FIG. 11.

In FIG. 12, the layer shown as the first wiring member layer WL18 may be a first wiring element, and the layer shown as the second wiring member layer WL28 may be a second wiring element. The first wiring element and the second wiring element may be electrically connected to each other. In addition, although only the first and second wiring elements are shown herein for convenience, the first wiring member layer WL18 may further include wiring elements other than the first wiring element, and the second wiring member layer WL28 may further include wiring elements other than the second wiring element.

FIGs. 13A to 13C are sectional views showing a method of forming a redistribution layer structure according to an embodiment of the present invention.

Referring to FIG. 13A, a substructure ST17 including an electrode pad PD17 may be prepared. The substructure ST17 may be a chip (semiconductor chip) or a package substrate. A first insulating layer NL17 may be formed on the substructure ST17. The first insulating layer NL17 may have one or more openings V17 configured to expose the electrode pad PD17. The one or more openings V17 may be open to a given target region within a size range of the target region. The one or more openings V17 may be the regions in which electrically identical elements (identical bodies) to which the same electrical signal is applied are formed. The target region may be a given surface region of the electrode pad PD17 or a region corresponding thereto. The first insulating layer NL17 may have an unetched portion U17 configured to improve the flatness of the redistribution layer structure in the remaining region excluding the one or more openings V17 in the space corresponding to the target region. The unetched portion U17 may be disposed between two or more openings, or may be disposed such that more than half of the unetched portion is surrounded by one opening.

Referring to FIG. 13B, a first wiring member layer WL17 disposed so as to at least partially fill the one or more openings V17 may be formed on the first insulating layer NL17. The first wiring member layer WL17 may include the electrically identical elements formed in the one or more openings V17.

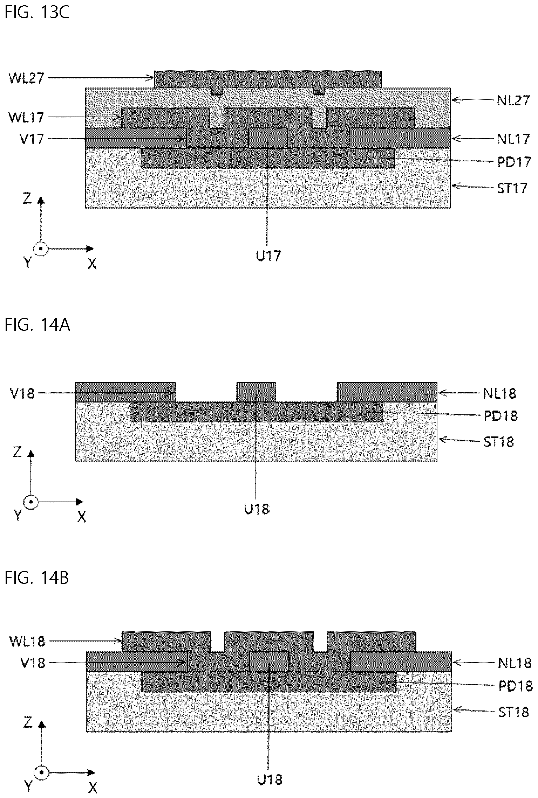

Referring to FIG. 13C, a second insulating layer NL27 configured to at least partially cover the first wiring member layer WL17 may be formed on the first insulating layer NL17, and a second wiring member layer WL27 may be formed on the second insulating layer NL27. The redistribution layer structure of FIG. 13C may correspond to the redistribution layer structure described with reference to FIG. 10.

FIGs. 14A to 14D are sectional views showing a method of forming a redistribution layer structure according to another embodiment of the present invention.

Referring to FIG. 14A, a substructure ST18 including an electrode pad PD18 may be prepared. The substructure ST18 may be a chip (semiconductor chip) or a package substrate. A first insulating layer NL18 may be formed on the substructure ST18. The first insulating layer NL18 may have one or more first openings V18 configured to expose the electrode pad PD18. The one or more first openings V18 may be open to a given first target region within a size range of the first target region. The one or more openings V18 may be the regions in which first electrically identical elements (identical bodies) to which the same electrical signal is applied are formed. The first target region may be a given surface region of the electrode pad PD18 or a region corresponding thereto. The first insulating layer NL18 may have a first unetched portion U18 configured to improve the flatness of the redistribution layer structure in the remaining region excluding the one or more openings V18 in the space corresponding to the first target region. The first unetched portion U18 may be disposed between two or more first openings, or may be disposed such that more than half of the first unetched portion is surrounded by one first opening.

Referring to FIG. 14B, a first wiring member layer WL18 disposed so as to at least partially fill the one or more first openings V18 may be formed on the first insulating layer NL18. The first wiring member layer WL18 may include the first electrically identical elements formed in the one or more first openings V18.

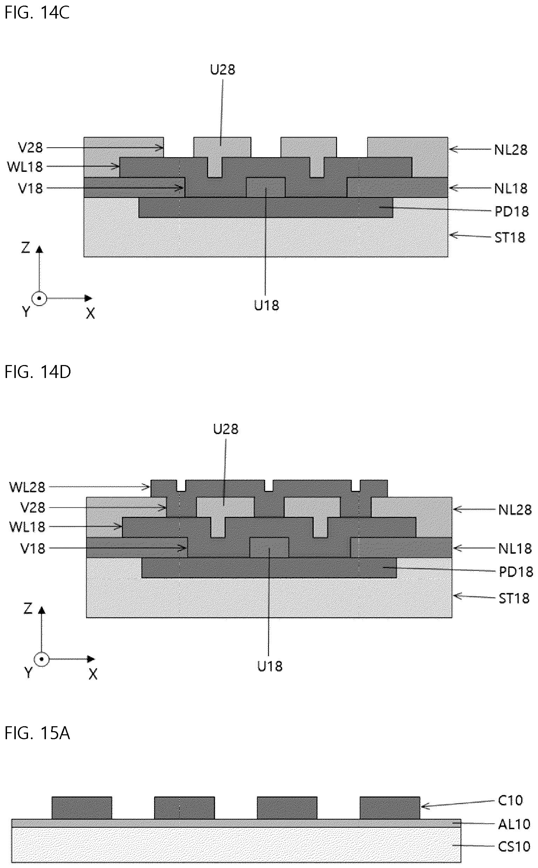

Referring to FIG. 14C, a second insulating layer NL28 configured to at least partially cover the first wiring member layer WL18 may be formed on the first insulating layer NL18. The second insulating layer NL28 may have one or more second openings V28 configured to expose the first wiring member layer WL18. The one or more second openings V28 may be open to a given second target region within a size range of the second target region. The one or more second openings V28 may be the regions in which second electrically identical elements (identical bodies) to which the same electrical signal is applied are formed. The second target region may be a given surface region of the first wiring member layer WL18. The second insulating layer NL28 may have a second unetched portion U28 configured to improve the flatness of the redistribution layer structure in the remaining region excluding the one or more second openings V28 in the space corresponding to the second target region. The second unetched portion U28 may be disposed between two or more second openings, or may be disposed such that more than half of the second unetched portion is surrounded by one second opening.

Referring to FIG. 14D, a second wiring member layer WL28 disposed so as to at least partially fill the one or more second openings V28 may be formed on the second insulating layer NL28. The second wiring member layer WL28 may include the second electrically identical elements formed in the one or more second openings V28. The redistribution layer structure of FIG. 14D may correspond to the redistribution layer structure described with reference to FIG. 12.

The method of forming the redistribution layer structure according to the embodiment of the present invention may be applied to a method of manufacturing a semiconductor package device. A method of manufacturing a semiconductor package device according to an embodiment of the present invention, which is a method of manufacturing a semiconductor package device including a chip (die) and a redistribution layer structure electrically connected to the chip, may include forming the redistribution layer structure using the method described above. As a non-limiting example, the method of manufacturing the semiconductor package device may be based on a wafer level package (WLP) method or a panel level package (PLP) method.

FIGs. 15A to 15D are sectional views showing a method of manufacturing a semiconductor package device to which a method of forming a redistribution layer structure according to an embodiment of the present invention is applied.

Referring to FIG. 15A, an adhesive layer AL10 may be provided on a carrier substrate CS10, and a plurality of chips C10 may be attached to the adhesive layer AL10. In other words, the plurality of chips C10 may be attached to the carrier substrate CS10 in the state in which the adhesive layer AL10 is interposed therebetween. The carrier substrate CS10 may be a wafer or a panel. The plurality of chips C10 may be attached to the carrier substrate CS10, for example, in a face-down manner. The adhesive layer AL10 may be an adhesive film.

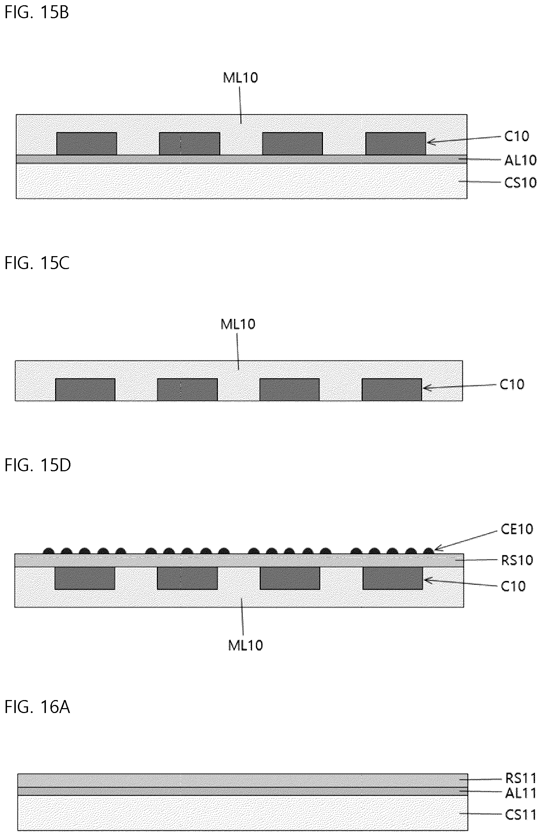

Referring to FIG. 15B, a molding layer ML10 configured to cover the plurality of chips C10 may be formed on the carrier substrate CS10. The molding layer ML10 may include a polymer material. For example, the molding layer ML10 may include a molding compound.

Referring to FIG. 15C, the carrier substrate CS10 (FIG. 15B) may be removed from the plurality of chips C10 and the molding layer ML10. At this time, the adhesive layer AL10 (FIG. 15B) may also be removed.

Referring to FIG. 15D, a redistribution layer structure RS10 may be formed on the plurality of chips C10 and the molding layer ML10. The redistribution layer structure RS10 may include a configuration according to an embodiment of the present invention. The redistribution layer structure RS10 may be formed so as to be in contact with an active surface portion of each of the plurality of chips C10. In addition, a plurality of electrical connection elements CE10 may be further formed on the redistribution layer structure RS10. As a non-limiting example, the plurality of electrical connection elements CE10 may include solder balls or bumps. The plurality of chips C10, the molding layer ML10, the redistribution layer structure RS10, and the plurality of electrical connection elements CE10 may be said to constitute a package structure.

Subsequently, although not shown, the package structure may be divided (cut) into package device units. This may be performed according to a conventional dividing (cutting) method. As a result, individualized semiconductor package devices may be obtained.

FIGs. 16A to 16E are sectional views showing a method of manufacturing a semiconductor package device to which a method of forming a redistribution layer structure according to another embodiment of the present invention is applied.

Referring to FIG. 16A, an adhesive layer AL11 may be provided on a carrier substrate CS11, and a redistribution layer structure RS11 may be formed on the adhesive layer AL11. The redistribution layer structure RS11 may include a configuration according to an embodiment of the present invention. The carrier substrate CS11 may be a wafer or a panel.

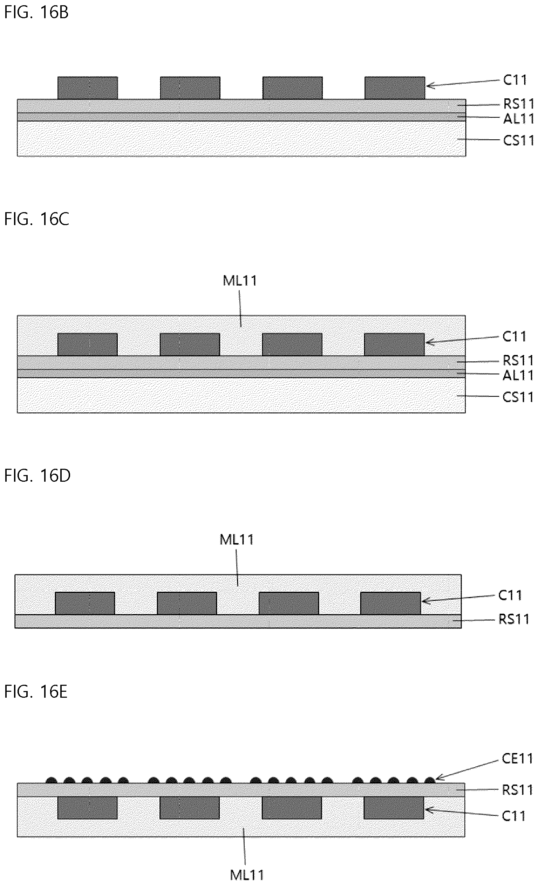

Referring to FIG. 16B, a plurality of chips C11 may be attached to the redistribution layer structure RS11. The plurality of chips C11 may be attached to the redistribution layer structure RS11, for example, in a face-down manner.

Referring to FIG. 16C, a molding layer ML11 configured to cover the plurality of chips C11 may be formed on the redistribution layer structure RS11. The molding layer ML11 may include a polymer material.

Referring to FIG. 16D, the carrier substrate CS11 (FIG. 16C) may be removed from the plurality of chips C11 and the molding layer ML11. At this time, the adhesive layer AL11 (FIG. 16C) may be also removed. The adhesive layer AL11 (FIG. 16C) may also serve as a release layer having adhesive properties.

Referring to FIG. 16E, a plurality of electrical connection elements CE11 may be formed on the redistribution layer structure RS11. As a non-limiting example, the plurality of electrical connection elements CE11 may include solder balls or bumps. The plurality of chips C11, the molding layer ML11, the redistribution layer structure RS11, and the plurality of electrical connection elements CE11 may be said to constitute a package structure. Although not shown, the package structure may be divided (cut) into package device units. As a result, individualized semiconductor package devices may be obtained.

The method of forming the redistribution layer structure according to the embodiments of the present invention may be applied to a wafer level package (WLP) or panel level package (PLP) type semiconductor package. In addition, the method of forming the redistribution layer structure may be applied to a fan-in type semiconductor package as well as a fan-out type semiconductor package. The method of forming the redistribution layer structure may be applied to a semiconductor package of a chip-first (i.e., die-first) type semiconductor package and a chip-last (i.e., die-last) type semiconductor package. The forming method of the redistribution layer structure may be applied to a face-down type semiconductor package and a face-up type semiconductor package. In addition, the method of forming the redistribution layer structure may also be applied to form a redistribution layer on a package substrate having a plurality of electrode pads, in which case a semiconductor packaging process can be performed on the package substrate on which the redistribution layer is formed.

A semiconductor package device according to an embodiment of the present invention may include a chip (semiconductor chip) and a redistribution layer structure electrically connected to the chip, and the redistribution layer structure may include features of the redistribution layer structure according to the embodiment described with reference to FIGs. 1A to 2B, 4 to 8, 10, and 12.

In addition, the redistribution layer structure and the methods of forming the same according to the embodiments of the present invention may be applicable to the manufacture of an electronic device other than the semiconductor package. The embodiments of the present invention may be applicable to any electronic device/semiconductor device to which the redistribution layer structure is applied.

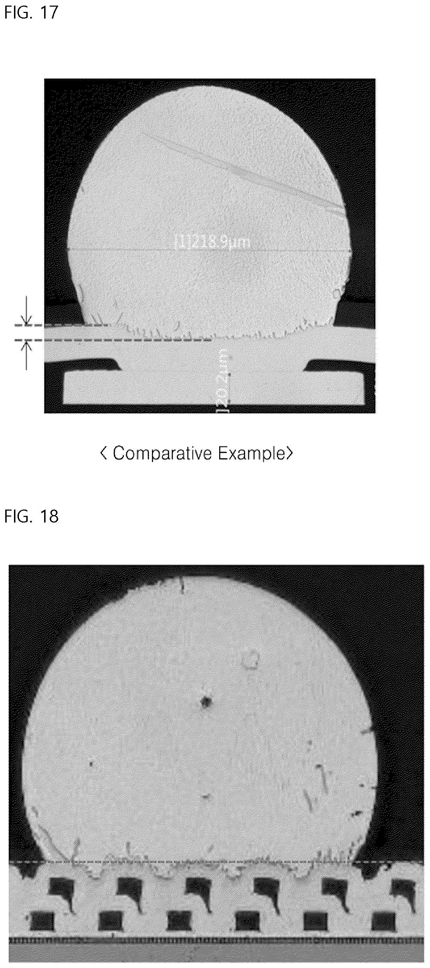

FIG. 17 is a sectional photographic image showing a part of a semiconductor package device manufactured according to a comparative example.

Referring to FIG. 17, a solder ball may be formed on a redistribution layer structure according to the comparative example. The redistribution layer structure may have great bending and height difference (step) at the surface thereof due to the influence of a relatively large via hole. The sink problem of the solder ball may occur, and the sagging problem of a pattern portion may occur. This may negatively affect the reliability and performance of the semiconductor package device.

FIG. 18 is a sectional photographic image showing a part of a semiconductor package device manufactured according to an embodiment of the present invention.

Referring to FIG. 18, a solder ball may be formed on a redistribution layer structure according to the embodiment. The redistribution layer structure may be configured to include, for example, an array of small vias or a via having an at least partial ring (donut) structure. In this case, the topology and flatness of the redistribution layer structure may be improved. The sink problem of the solder ball may also be reduced. As a result, the reliability and performance of the semiconductor package device may be improved.

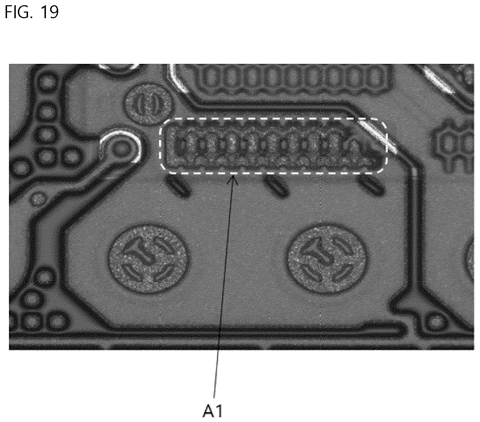

FIG. 19 is a photographic image showing a part of a surface portion of a semiconductor package device manufactured according to an embodiment of the present invention.

Referring to FIG. 19, the region indicated by A1 may include the configuration of the redistribution layer described with reference to FIG. 12. For example, the region indicated by A1 may include a configuration similar to the configuration of the second insulating layer NL28 and the second wiring member layer WL28 described with reference to FIG. 12. Consequently, the region indicated by A1 may have improved surface flatness.

As is apparent from the above description, according to embodiments of the present invention, it is possible to implement a redistribution layer (RDL) structure capable of improving topology and flatness, thereby improving reliability, and a device (e.g., semiconductor package device) including the same. When the redistribution layer (RDL) structure according to the embodiment of the present invention is used, it is possible to prevent problems such as bending and sagging (sagging of a pattern portion) due to a large via hole (opening) while securing excellent electrical connectivity between components, and therefore it is possible to reduce the defect rate of devices and to improve reliability.

For example, a redistribution layer (RDL) structure and a method of forming the same according to embodiments of the present invention may be usefully applied to advanced packaging processes, such as a fan-in process, a fan-out process, and an integrated packaging process in which a plurality of chips is packaged together. In addition, the redistribution layer (RDL) structure and the method of forming the same according to the embodiments of the present invention may be applied to a chip-first (i.e., die-first) process and a chip-last (i.e., die-last) process. In addition, the redistribution layer (RDL) structure and the method of forming the same according to the embodiments of the present invention may be applied to a package substrate. Furthermore, the redistribution layer (RDL) structure and the method of forming the same according to the embodiments of the present invention may be applied to the manufacture of various electronic/semiconductor devices.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the redistribution layer structure, the method of forming the redistribution layer structure, the semiconductor package device including the redistribution layer structure, and the method of manufacturing the semiconductor package device including the redistribution layer structure according to the embodiments described with reference to FIGs. 1A to 2B, 4 to 8, 10, 12, 13A to 16E, 18, and 19 may be subject to various substitutions, changes, and modifications without departing from the technical ideas of the present invention. The scope of the invention is therefore not to be defined by the embodiments described above but by the technical ideas recited in the appended claims.

## Claims

1. A semiconductor package device comprising:
a chip; and
a redistribution layer structure electrically connected to the chip, wherein the redistribution layer structure comprises:
a first insulating layer having one or more openings open to a given target region within a size range of the target region, the one or more openings being regions in which electrically identical elements to which the same electrical signal is applied are formed, and having an unetched portion configured to improve flatness of the redistribution layer structure in a remaining region excluding the one or more openings in a space corresponding to the target region, the unetched portion being disposed between two or more openings or disposed such that more than half of the unetched portion is surrounded by one opening; and
a first wiring member layer disposed on the first insulating layer so as to at least partially fill the one or more openings, the first wiring member layer comprising the electrically identical elements formed in the one or more openings.

2. The semiconductor package device according to claim 1, wherein
the first insulating layer comprises a plurality of openings formed in the target region so as to be spaced apart from each other, and
the unetched portion is provided between the plurality of openings.

3. The semiconductor package device according to claim 1, wherein
the first insulating layer comprises an opening having a ring structure or a partial ring structure in the target region, and
the unetched portion is provided so as to be surrounded by the ring structure or the partial ring structure.

4. The semiconductor package device according to claim 1, wherein at least a part of the unetched portion is located in a region corresponding to a central part of the target region.

5. The semiconductor package device according to claim 1, wherein the one or more openings have a diameter or line width of 1 to 10 µm.

6. The semiconductor package device according to claim 1, wherein the target region is a given surface region of one electrode pad or a region corresponding thereto.

7. The semiconductor package device according to claim 1, wherein the redistribution layer structure further comprises:
a second insulating layer disposed on the first insulating layer so as to at least partially cover the first wiring member layer; and
a second wiring member layer disposed on the second insulating layer.

8. The semiconductor package device according to claim 7, wherein
the target region is a first target region, the one or more openings are first openings, the unetched portion is a first unetched portion, and the electrically identical elements are first electrically identical elements,
the second insulating layer has one or more second openings open to a given second target region of the first wiring member layer within a size range of the second target region, the one or more second openings being regions in which second electrically identical elements to which the same electrical signal is applied are formed, and the second insulating layer has a second unetched portion configured to improve flatness of the redistribution layer structure in a remaining region excluding the one or more second openings in a space corresponding to the second target region, the second unetched portion being disposed between two or more second openings or disposed such that more than half of the second unetched portion is surrounded by one second opening; and
the second wiring member layer is disposed on the second insulating layer so as to at least partially fill the one or more second openings, the second wiring member layer comprising the second electrically identical elements formed in the one or more second openings.

9. The semiconductor package device according to claim 8, wherein
the second insulating layer comprises a plurality of second openings formed in the second target region so as to be spaced apart from each other, and
the second unetched portion is provided between the plurality of second openings.

10. The semiconductor package device according to claim 8, wherein
the second insulating layer comprises a second opening having a ring structure or a partial ring structure in the second target region, and
the second unetched portion is provided so as to be surrounded by the ring structure or the partial ring structure.

11. A method of forming a redistribution layer structure, the method comprising:
forming a first insulating layer having one or more openings open to a given target region within a size range of the target region, the one or more openings being regions in which electrically identical elements to which the same electrical signal is applied are formed, and having an unetched portion configured to improve flatness of the redistribution layer structure in a remaining region excluding the one or more openings in a space corresponding to the target region, the unetched portion being disposed between two or more openings or disposed such that more than half of the unetched portion is surrounded by one opening; and
forming a first wiring member layer disposed on the first insulating layer so as to at least partially fill the one or more openings, the first wiring member layer comprising the electrically identical elements formed in the one or more openings.

12. The method according to claim 11, wherein
the first insulating layer comprises a plurality of openings formed in the target region so as to be spaced apart from each other, and
the unetched portion is provided between the plurality of openings.

13. The method according to claim 11, wherein
the first insulating layer comprises an opening having a ring structure or a partial ring structure in the target region, and
the unetched portion is provided so as to be surrounded by the ring structure or the partial ring structure.

14. A method of manufacturing a semiconductor package device comprising a chip and a redistribution layer structure electrically connected to the chip, the method comprising forming the redistribution layer structure using the method according to any one of claims 11-13.

15. The method according to claim 14, wherein the method of manufacturing the semiconductor package device is based on a wafer level package (WLP) method or a panel level package (PLP) method.
